# DEMANDE DE BREVET EUROPEEN

(11) **EP 1 475 727 A1**
(43) Date de publication de la demande: **10.11.2004**
(21) Numéro de dépôt: 04291088.5
(22) Date de dépôt: 27.04.2004
(51) Int. Cl.: G06F 17/50

(54) **Dispositif d'émulation d'une ou plusieurs puces de circuits intégrés**

(30) Priorité: 07.05.2003 FR 0305538
(71) Demandeur: Arteris, 75008 Paris (FR)
(72) Inventeur: Douady, César, 91400 Orsay (FR); Boucard, Philippe, 78150 Le Chesnay (FR)
(74) Mandataire: Casalonga, Axel

(57) **Abrégé**

Dispositif d'émulation d'une ou plusieurs puces de circuits intégrés comprenant des cartes électroniques (11) reliées entre elles par un bus de communication (12), lesdites cartes électroniques (11) possédant des unités d'émulation programmables (16). Le dipositif d'émulation comprend des liaisons point-à-point configurables (18), et, la ou les puces comprenant des modules multi-synchrones (4) et au moins un module de gestion de communication asynchrone (5) de messages, un module est modélisé par au plus une unité d'émulation programmable (16).

## Description

La présente invention concerne un dispositif d'émulation d'une ou plusieurs puces de circuits intégrés.

On entend par émulation une simulation rapide avec des moyens matériels et logiciels.

L'évolution rapide des technologies permet d'intégrer de plus en plus de fonctions logiques et de composants sur une puce de circuits intégrés. Les composants et leurs connexions sont donc de plus en plus petits, ce qui a pour conséquence une augmentation des processus parasites dans les liaisons entre les composants. En effet, plus les liaisons sont fines, plus leurs résistances électriques et leurs capacités de couplage augmentent et plus les délais de transmission des données sont importants. Ces problèmes de délais dus à des connexions deviennent de plus en plus importants avec le développement des technologies microélectroniques sub-microniques. Il est donc de plus en plus difficile de maintenir une cohérence fonctionnelle de sous-ensembles synchrones, cadencés par une même horloge, sur une puce de circuits intégrés. Il faut également tenir compte d'une augmentation souhaitée du nombre croissant d'entrées/sorties présentes sur une puce de circuits intégrés, tandis que le nombre de connexions via des interfaces externes n'augmente pas dans les mêmes proportions.

Des dispositifs et procédés de simulation et d'émulation de circuits intégrés existent. On simule le comportement logique de circuits intégrés en utilisant un langage approprié, par exemple le langage C, VHDL ou Verilog, sur une ou plusieurs machines d'usage général. Un circuit intégré peut être émulé en utilisant des circuits logiques programmables, par exemple des FPGA ("Field Programmable Gate Array" en langue anglaise), configurés selon la liste des interconnexions ou "netlist" en langue anglaise, et en excitant ces circuits logiques programmables afin de vérifier leur comportement.

Lors d'une émulation, la vitesse d'exécution est nettement supérieure à une simulation, car l'implémentation est directement matérielle et proche du circuit, tandis qu'une simulation utilise une représentation effectuée à partir d'un langage informatique évolué. Une simulation décrit donc le comportement du circuit en utilisant de nombreuses fois les ressources limitées d'un ou plusieurs processeurs. La rapidité de l'émulation permet d'effectuer un nombre supérieur de tests d'un facteur d'environ mille par rapport au nombre de tests effectués par une simulation dans un même délai.

Pour réaliser une machine d'émulation de circuits intégrés, on utilise une technologie à base de circuits logiques programmables. Or, la description d'un circuit intégré à émuler est généralement de complexité importante et nécessite d'utiliser plusieurs circuits logiques programmables. Cela pose alors des problèmes de partition du circuit en sous-circuits de taille raisonnablement petite pour être chacun modélisé par un unique circuit logique programmable. Ces différents circuits logiques programmables doivent communiquer entre eux afin de recréer les communications entre ces différents sous-circuits. Cette partition n'est généralement pas aisée, et le nombre de communications entre les différents sous-circuits peut être élevé. Cela entraîne des difficultés de réalisations de telles machines, et un coût associé important.

Le document accessible à l'adresse http://www.crossbowip.com/docs/doc_ppt_pdf/2Dfabric_operation_pdf. pdf de la société Crossbow propose un émulateur basé sur une partition du circuit en sous-circuits synchrones. Cependant cet émulateur n'est pas reconfigurable.

Au vu de ce qui précède, l'invention a pour but de TRANSPOSER une architecture gérant la communication asynchrone entre des modules synchrones de circuits intégrés, sur une machine afin d'émuler, à faible coût, des circuits intégrés conçus avec cette architecture pour laquelle le problème de partition de la liste des interconnexions d'un circuit intégré est géré dès la conception du circuit.

Ainsi, selon un aspect de l'invention, il est proposé un dispositif d'émulation d'une ou plusieurs puces de circuits intégrés comprenant des cartes électroniques reliées entre elles par un bus de communication. Lesdites cartes électroniques possèdent des unités d'émulation programmables. Le dispositif d'émulation comprend en outre des liaisons point-à-point configurables. La ou les puces comprenant des modules multi-synchrones et au moins un module de gestion de communication asynchrone de messages, un module est modélisé par au plus une unité d'émulation programmable. On entend par module multi-synchrone un sous-ensemble de circuit cadencé par une ou plusieurs horloges dédiées audit module. Ces modules multi-synchrones comprennent chacun un ensemble de composants.

Ce dispositif permet d'émuler, à faible coût, des circuits conçus avec une telle architecture qui réduit le problème des délais de transmission des données entre composants qui apparaîssent avec les technologies microélectroniques sub-microniques. En effet, les délais au sein d'un module multi-synchrone sont maîtrisés, notamment car la taille de ces modules est limitée.

Dans un mode de réalisation préféré, un même protocole spécifique prédéterminé est utilisé pour les communications entre les unités d'émulation programmables modélisant les modules de la ou les puces, et pour la communication entre les modules de la ou les puces.

L'architecture du dispositif d'émulation est alors basée sur l'architecture du circuit à émuler.

Dans un mode de réalisation avantageux, le dispositif est couplé à un ordinateur comprenant des moyens matériels et logiciels pour programmer ledit dispositif visant à émuler la ou les puces de circuits intégrés, et notamment pour commander les unités d'émulation programmables modélisant les modules de la ou les puces.

Dans un mode de réalisation préféré, les unités d'émulation programmables sont des circuits logiques programmables par l'utilisateur.

Dans un mode de réalisation avantageux, chaque circuit logique programmable comprend une ou plusieurs mémoires associées aptes à stocker les traces de l'émulation, afin de fournir à l'utilisateur des informations sur le comportement de la ou les puces émulées.

Dans un mode de réalisation préféré, les moyens matériels et logiciels pour programmer ledit dispositif, ainsi que les cartes électroniques, comprennent des moyens pour aider l'utilisateur à configurer ledit dispositif.

En effet cela permet à l'utilisateur d'être guidé, par exemple lors des branchement de connexions des cartes électroniques, par exemple au moyen de voyants lumineux électroniques sur les cartes électroniques, voyants commandés par l'intermédiaire de l'ordinateur.

Dans un mode de réalisation avantageux, le dispositif comprend des moyens pour transmettre des données en même temps que leurs propres informations de cadencement d'horloge.

On met ainsi en oeuvre un aspect du protocole spécifique prédéterminé, utilisé pour les communications entre les unités d'émulation programmables, qui transmet des données en même temps que leurs propres informations de cadencement d'horloge.

D'autres buts, caractéristiques et avantages de l'invention apparaîtront à la lecture de la description suivante, donnée à titre d'exemple non limitatif, et faite en référence aux dessins annexés sur lesquels :
- la figure 1 est un schéma synoptique d'un dispositif de gestion de communication de messages d'une puce de circuits intégrés ;
- la figure 2 est un schéma synoptique d'une variante d'un dispositif de gestion de communication d'une puce de circuits intégrés ;
- la figure 3 est un schéma fonctionnel d'un module de gestion de communication asynchrone de messages ;
- la figure 4 est un schéma synoptique d'un dispositif d'émulation d'une puce de circuits intégrés comprenant un dispositif de gestion de communication, selon un aspect de l'invention.

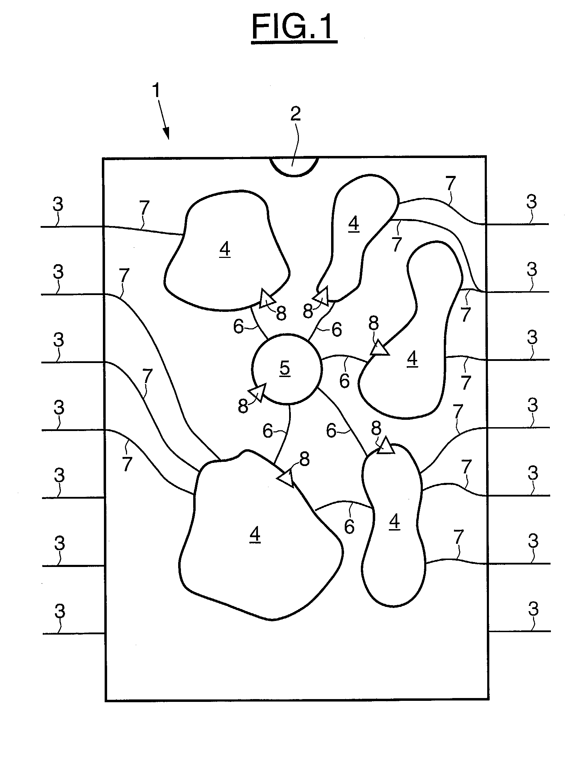

Sur la figure 1, on a représenté une puce 1 de circuits intégrés avec un indicateur d'orientation 2, et des pattes 3 pour la communication avec l'extérieur de ladite puce 1. Les composants de la puce 1, de plus en plus nombreux, sont regroupés en modules multi-synchrones 4. On entend par module multi-synchrone un sous-ensemble de circuit cadencé par une ou plusieurs horloges dédiées audit module.

Un module de gestion de communication asynchrone 5 de messages, relié à au moins deux modules multi-synchrones 4, ici tous les modules multi-synchrones 4, par des liaisons point-à-point 6, gère la communication entre les différents modules 4 de la puce 1 de circuits intégrés. Les modules 4 communiquent avec l'extérieur de la puce 1 par des liaisons 7 entre les modules et des pattes 3 de la puce 1. Deux modules multi-synchrones 4 peuvent également, si les contraintes de conception l'obligent, communiquer directement par une liaison point-à-point 6 identique aux liaisons point-à-point 6 entre le module de gestion de communication asynchrone 5 et chaque module multi-synchrone 4. Il est toutefois préférable que les communications entre deux modules synchrones 4 passent par le module de gestion de communication asynchrone 5.

Un ensemble 8 d'au moins une horloge, dédiée à un unique module multi-synchrone, détermine les références de cadencement des fréquence de fonctionnement dudit module multi-synchrone 4. Il est à noter que le module 5 est un cas particulier de module multi-synchrone , et qu'il possède également son propre ensemble 8 d'au moins une horloge.

Un unique protocole de communication prédéterminé spécifique est utilisé pour les communications entre lesdits modules de la puce 1 s'effectuant sur les liaisons 6.

Chaque liaison point-à-point 6 comprend, pour chaque extrémité, des moyens d'émission et des moyens de réception de messages, chaque moyen de réception comprenant une mémoire de type premier entré premier sorti, communément appelée "pile FIFO".

Sur une liaison 6, les données d'horloges et les autres données sont envoyées simultanément. Au cours du transport, les données d'horloge subissent un déphasage, et les données d'horloge d'arrivée n'ont pas la même phase que les données d'horloge de départ. Les autres données subissent alors une dispersion temporelle. Si la dispersion temporelle est trop importante, une re-synchronisation est effectuée.

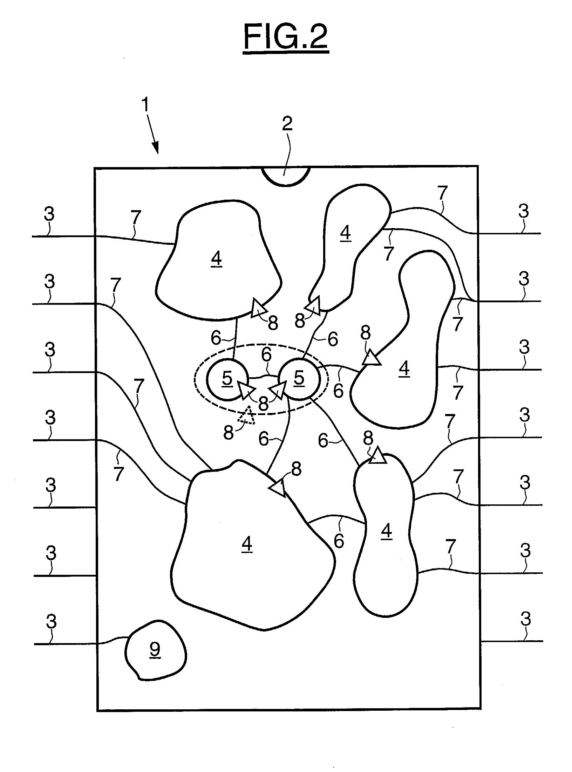

La figure 2 présente une variante du dispositif de la figure 1. Le dispositif comprend au moins deux modules de gestion de communication asynchrones 5, ici deux sont représentés. Il peut être nécessaire, en regard de la complexité d'un circuit et de sa partition en un nombre important de modules multi-synchrones, de disposer de plusieurs modules de gestion de communication asynchrone 5. De plus, le circuit peut comprendre un ou plusieurs modules 9, dont un seul est représenté ici, non reliés aux modules de gestion de communication asynchrone (5). Ce dispositif peut être vu de l'extérieur comme un unique module de gestion de communication asynchrone permettant de retrouver un dispositif semblable à celui de la figure 1.

Cependant il existe une différence, car le fait de mettre plusieurs modules de gestion de communication asynchrone nécessite des étapes supplémentaires pour la communication entre deux modules synchrones, notamment une liaison 6 supplémentaire pour le transfert des échanges de données, et plusieurs traitements successifs correspondant au nombre de modules de gestion de communication asynchrone.

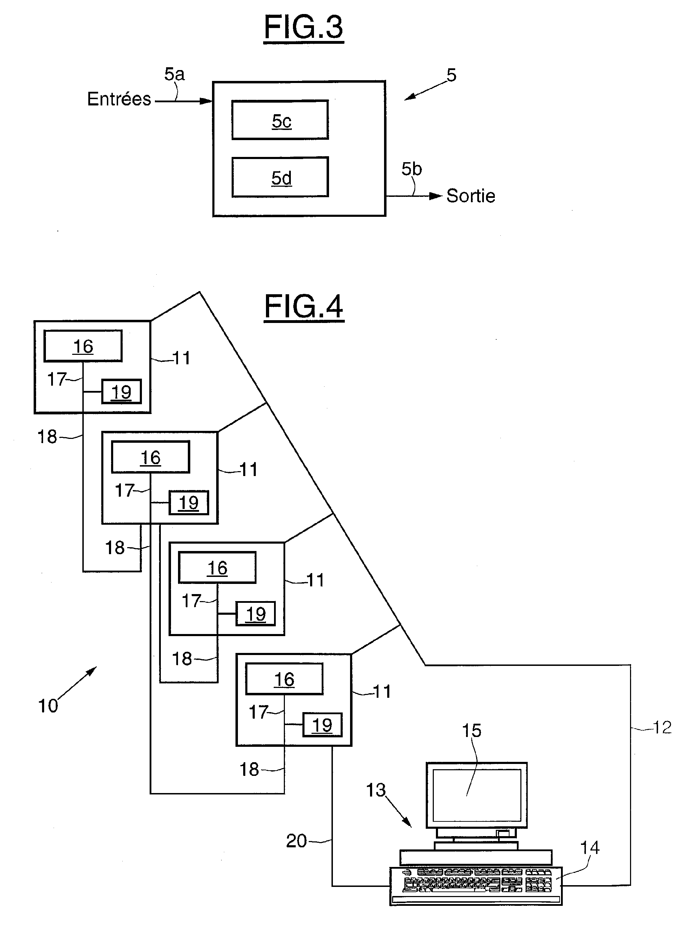

La figure 3 est un schéma fonctionnel d'un module de gestion de communication asynchrone 5. Celui-ci comprend des entrées 5a de réception de messages de données provenant d'autres modules et des sorties 5b de transmission de messages de données vers d'autres modules. Les messages en entrée sont stockés temporairement, par exemple dans une mémoire de type premier entré premier sorti, communément appelée "pile FIFO" des moyens de réception de messages d'une liaison point-à-point 6 . Ce stockage temporaire permet de pouvoir gérer les messages en entrée, même si ceux-ci arrivent à une cadence supérieure à la capacité de traitement des messages du module 5. Le module de gestion de communication asynchrone 5 comprend en outre des moyens 5c pour aiguiller des messages de sortie vers leur module destinataire, ainsi que des moyens 5d pour gérer l'aiguillage des messages de sortie. Un message en entrée est donc stocké dans la pile FIFO des moyens de réception de messages d'une liaison point-à-point 6, puis pris en compte par le module 5, qui va gérer son aiguillage vers son module synchrone 4 de destination par les moyens 5c et 5d. Ce message quitte alors le module 5 par la sortie 5b et transite par les moyens d'émission de messages d'une liaison point-à-point 6 au module synchrone 4 de destination du message.

La figure 4 représente un dispositif d'émulation d'une ou plusieurs puces 1 de circuits intégrés dont la conception a été faite selon la description de la figure 1.

Le dispositif d'émulation 10 comprend un ensemble de cartes électroniques 11 reliées entre-elles par un bus de communication 12 de commande et de contrôle, relié à un ordinateur 13. Cet ordinateur 13 possède une unité centrale 14 qui comprend des moyens matériels et logiciels permettant de gérer l'émulation et de proposer une interface conviviale pour l'utilisateur sur un écran 15.

Chaque carte électronique 11 comprend au moins un circuit logique programmable 16, relié par une liaison 17 à des connexions point-à-point 18 configurables par l'utilisateur. En effet, selon le circuit à émuler, elles connectent entre-elles des cartes électroniques en fonction de la modélisation du circuit par les circuits logiques programmables 16. Les connexions 18 sont les équivalents des liaisons point-à-point 6 et font transiter les mêmes messages et comprennent, à chaque extrémité, les mêmes moyens d'émission et de réception de messages. Chacun des circuits logiques programmables comprend en outre une mémoire 19 associée permettant notamment de stocker des informations, appelées couramment traces dans le domaine informatique, qui peuvent être fournies à l'utilisateur par l'intermédiaire de l'écran 15 de l'ordinateur 13. Les circuits logiques programmables 16 sont programmés par l'intermédiaire d'une liaison à haut débit 20. La liaison 20 est une liaison 18 ayant un rôle particulier de programmation des circuits logiques programmables 16. Les traces permettront à l'utilisateur d'étudier le comportement de la puce à circuits intégrés qu'il a émulée. Avantageusement ces informations ou traces seront configurables par l'utilisateur.

Les modules synchrones 4 de la puce 1, sont modélisés chacun dans un unique circuit logique programmable 16 du dispositif d'émulation 10. On résout ainsi des problèmes liés à la partition de circuits à émuler. De même, le module de gestion de communication asynchrone 5 de ladite puce 1 est modélisé dans un unique circuit logique programmable 16. De cette manière, l'architecture de conception de la puce 1 est transposée à l'émulation de ladite puce 1.

De surcroît, le protocole de communication utilisé pour les communications entre les circuits logiques programmables 16, modélisant les modules 4 et 5 de la puce, est le protocole de communication spécifique prédéterminé utilisé pour la communication entre les modules de la puce.

Le circuit logique programmable 16, modélisant le module de gestion de communication asynchrone 5, gère alors la communication entre les différents circuits logiques programmables 16, modélisant les modules 4 et 5 de la puce 1.

L'invention propose un moyen d'émulation d'une puce de circuits intégrés, en transposant l'architecture de conception de la puce à l'architecture du dispositif d'émulation. On obtient alors un émulateur efficace, reconfigurable, et de coût fortement réduit du fait de sa simplicité, permettant d'émuler le comportement d'une puce de circuits intégrés.

## Revendications

1. Dispositif d'émulation d'une ou plusieurs puces de circuits intégrés comprenant des cartes électroniques (11) reliées entre elles par un bus de communication (12), lesdites cartes électroniques (11) possédant des unités d'émulation programmables (16), **caractérisé par le fait qu'**il comprend des liaisons point-à-point configurables (18 ), et que, la ou les puces comprenant des modules multi-synchrones (4) et au moins un module de gestion de communication asynchrone (5) de messages, un module est modélisé par au plus une unité d'émulation programmable (16).

2. Dispositif selon la revendication 1, **caractérisé par le fait qu'**un même protocole spécifique prédéterminé est utilisé pour les communications entre les unités d'émulation programmables (16) modélisant les modules (4, 5) de la ou les puces (1), et pour la communication entre les modules (4, 5) de la ou les puces (1).

3. Dispositif selon la revendication 1 ou 2, **caractérisé par le fait que** ledit dispositif est couplé à un ordinateur (13) comprenant des moyens matériels et logiciels pour programmer ledit dispositif visant à émuler la ou les puces (1) de circuits intégrés, et notamment pour commander les unités d'émulation programmables (16) modélisant les modules (4, 5) de la ou les puces (1).

4. Dispositif selon l'une quelconque des revendications 1 à 3, **caractérisé en ce que** les unités d'émulation programmables (16) sont des circuits logiques programmables par l'utilisateur.

5. Dispositif selon l'une quelconque des revendications 1 à 4, **caractérisé par le fait que** chaque circuit logique programmable (16) comprend une ou plusieurs mémoires associées (18) aptes à stocker les traces de l'émulation, afin de fournir à l'utilisateur des informations sur le comportement de la ou les puces (1) émulées.

6. Dispositif selon l'une quelconque des revendications 3 à 5, **caractérisé par le fait que** les moyens matériels et logiciels pour programmer ledit dispositif, ainsi que les cartes électroniques (11), comprennent des moyens pour aider l'utilisateur à configurer ledit dispositif.

7. Dispositif selon l'une quelconque des revendications 1 à 6, **caractérisé par le fait qu'**il comprend des moyens pour transmettre des données en même temps que leurs propres informations de cadencement d'horloge.
